# EUROPÄISCHE PATENTSCHRIFT

(11) **EP 0 721 965 B1**
(45) Veröffentlichungstag und Bekanntmachung des Hinweises auf die Patenterteilung: **19.03.2003**
(21) Anmeldenummer: 95119489.3
(22) Anmeldetag: 11.12.1995
(51) Int. Cl.: C08G 59/42, C08G 59/40, H01B 17/14, H01B 3/40

(54) **Flammwidriges Reaktionsharzsystem auf Basis von Epoxyverbindungen und phosphorhaltigen Anhydrid-Härtern**
Flame retardent reaction system of epoxy compounds and phosphorous containing anhydrid hardeners
Système de résine composite ignifugée de composés époxy et des durcisseurs d'anhydrides contenant de phosphore

(30) Priorität: 10.01.1995 DE 19500496; 17.02.1995 DE 19506010
(43) Veröffentlichungstag der Anmeldung: 17.07.1996
(73) Patentinhaber: SIEMENS AKTIENGESELLSCHAFT, 80333 München (DE)
(72) Erfinder: Plundrich, Winfried, D-82110 Germering (DE); Wipfelder, Ernst, Dr., D-81673 München (DE)

(56) Entgegenhaltungen:
- EP-A- 0 015 483
- EP-A- 0 409 308
- DE-A- 4 308 185
- DE-B- 1 300 695
- US-A- 5 262 456
- LEE, H. ET AL.: "Handbook of Epoxy Resins" , MC GRAW HILL , NEW YORK XP002001165 * Seite 12-2, Absatz 3 * * Seite 12-3, Zeile 16 *

## Beschreibung

Für die Abdeckung und Umhüllung elektrischer und elektronischer Bauelemente werden verarbeitungssichere flammwidrige Reaktionsharzformstoffe benötigt. Insbesondere bei passiven Bauelementen sind dabei Reaktionsharze gebräuchlich, die durch Verguß verarbeitet werden können (Gießharze). Im großen Umfang werden dazu Epoxidharze verwendet, die thermisch hoch belastbar sind und dabei gute mechanische und elektrische Eigenschaften aufweisen. Die niedermolekularen bzw. oligomeren Ausgangskomponenten lassen sich unter Verwendung verschiedenster Härter wie beispielsweise Carbonsäureanhydriden, Aminen, Phenolen oder Isocyanat bzw. durch ionische Polymerisation zu hochwertigen duroplastischen Materialien umsetzen. Der niedermolekulare bis oligomere Ausgangszustand der Epoxidharze ist für das vorteilhafte Verarbeitungsverhalten von Epoxidharzen verantwortlich. Sie können mit anorganischen inerten Füllstoffen hochgefüllt werden und sind selbst dann noch als Gießharz verarbeitbar.

Die flammwidrige Ausrüstung von Epoxidharzformstoffen geschieht heute allgemein mittels halogenhaltiger und speziell bromhaltiger aromatischer Komponenten. Diese eingelagerten Komponenten, die häufig Antimontrioxid als Synergisten enthalten, bereiten jedoch im Brandfall zusätzliche Probleme. Bei Verschwelung oder Verbrennung setzen sie korrosive und unter ungünstigen Bedingungen auch ökologisch und toxikologisch bedenkliche Zersetzungsprodukte frei. Für eine gefahrlose Entsorgung durch Verbrennung muß außerdem ein erheblicher technischer Aufwand betrieben werden.

In jüngster Zeit wurden phosphorhaltige Zusätze für Epoxidharze bekannt, die den Flammschutz verbessern. In der US 5 262 456 wird vorgeschlagen, ein Phosphin- bzw. Phosphonsäurederivat mit alkoholischen Hydroxylgruppen in einen Epoxidharzformstoff einzubinden. In der DE 42 37 132 wird vorgeschlagen, Phosphorkomponenten auf Phosphinoxid- bzw. Phosphonatbasis als den Flammschutz erhöhende Reaktionsharzkomponenten zu verwenden. In der DE 43 08 185 A1 wird vorgeschlagen, Polyepoxidverbindungen durch Umsetzung mit einem Phosphonsäureanhydrid in phosphorhaltige Epoxidverbindungen zu überführen und diese dann mit bekannten Härterkomponenten in flammwidrige Formstoffe zu vernetzen.

Gemeinsamer Nachteil dieser Phosphorverbindungen ist jedoch deren relativ niedriger Phosphorgehalt. Als Konsequenz daraus sind erhebliche Mengen dieser phosphorhaltigen Verbindungen erforderlich, um einen befriedigenden Flammschutz sicherzustellen. Wegen der insbesondere bei den phosphormodifizierten Epoxidharzen beobachteten hohen Viskosität dieser Phosphorkomponenten ergeben sich dabei deutliche Einschränkungen bei der Verarbeitbarkeit derartig modifizierter Reaktionsharzsysteme. Die Phosphonsäurederivate sind zwar in der Regel niederviskoser und damit für die Gießtechnik vorteilhafter einzusetzen. Sie zeigen jedoch eine schwächere Flammschutzwirkung und müssen deshalb in höherer Konzentration eingesetzt werden, was wiederum die Formstoffeigenschaften nachteilig beeinflussen kann.

Aus der EP 0 409 308A2 sind Härterkomponenten für Epoxidharze bekannt, die aus Phosphorpentoxid und Phosphorsäure oder Phosphorsäureestern hergestellt werden. Aus den Beispielen geht hervor, dass diese Reaktionsharzsysteme sofort beim Vermischen abreagieren und härten.

Aufgabe der vorliegenden Erfindung ist es daher, ein Gießharzsystem auf Epoxidharzbasis so zu modifizieren, daß ein daraus hergestellter Formstoff die für elektronische Bauelemente geforderten Flammschutzspezifikationen erfüllt, ohne daß dadurch die Verarbeitbarkeit des Gießharzsystems, die Formstoffeigenschaften oder die Zuverlässigkeit eines mit dem Formstoff abgedeckten oder umhüllten Bauelements negativ beeinflußt wird, und daß der Formstoff bei Verbrennung keine ökotoxikologisch bedenklichen Zersetzungsprodukte erzeugt.

Diese Aufgabe wird erfindungsgemäß durch ein Gießharzsystem nach Anspruch 1 gelöst. Ein Verfahren zur Herstellung eines flammwidrigen Gießharzformstoffes sowie weitere Ausgestaltungen der Erfindung sind den übrigen Ansprüchen zu entnehmen.

Die Erfindung geht auf die überraschende Entdeckung zurück, daß Phosphinsäureanhydride (Komponente B3) und Phosphonsäureanhydride (Komponente B2) in jedem Verhältnis mit den übrigen Komponenten eines an sich bekannten Gießharzsystems mischbar sind. Dabei ist es möglich, die Anhydride direkt oder besonders vorteilhaft in Abmischung mit gebräuchlichen, insbesondere flüssigen Carbonsäureanhydriden der Gießharzmasse zuzugeben. Tabelle 1 zeigt das Viskositätsverhalten am Beispiel des Propanphosphonsäureanhydrids (PPA) und des PPA/Hexahydrophthalsäureanhydrid (HHPSA)-Gemisches in Abhängigkeit von der Temperatur. Die Vorteile der PPA/HHPSA-Mischung für Gießharzanwendungen werden dabei offensichtlich.

**Tabelle 1**

| Kennwerte eines P-haltigen Anhydrids bzw. eines P-haltigen Anhydrid-Gemisches | | |
|---|---|---|
| Komponente | P-haltiges Anhydrid PPA | P-haltiges Anhydrid-Gemisch PPA/HHPSA (1:1) |
| Phosphorgehalt % | 29 | 14,5 |
| | | |
| Viskosität mPas | | |
| bei 25 °C | hochviskos | 2040 |
| 40°C | ca. 32000 | 680 |
| 60°C | 6500 | 240 |
| 80°C | 1500 | 120 |

Gegenüber einem Gießharzsystem ohne erfindungsgemäßes phosphorhaltiges Anhydrid werden weder die Härtungsreaktion noch die thermisch mechanischen Formstoffeigenschaften negativ beeinflußt. Da derartige phosphorhaltige Anhydride wie beispielsweise das Propanphosphonsäureanhydrid (PPA) einen hohen Phosphorgehalt von hier zum Beispiel 29 Gewichtsprozent aufweisen, sind nur minimale Mengen phosphorhaltiger Anhydride erforderlich, um einen ausreichenden Flammschutz zu bewirken. Gleichzeitig wird dadurch die Viskosität des Gießharzsystems nur unwesentlich erhöht, so daß seine Verarbeitbarkeit nicht beeinträchtigt wird.

Mit der Erfindung ist es also möglich, ein beliebiges Gießharzsystem auf Epoxid/Anhydridbasis in Richtung verbesserter Flammschutz zu modifizieren. Das bekannte Gießharzsystem kann dabei auf einen bestimmten Einsatz hin optimierte Eigenschaften aufweisen, die durch die erfindungsgemäße Modifizierung (Zugabe des phosphorhaltigen Anhydrids) nicht beeinträchtigt werden.

Ein ausreichend hoher Flammschutz wird bei einem Phosphorgehalt des Gießharzsystems von 1 bis 5 Gewichtsprozent erreicht. Die phosphorhaltigen Anhydride zeigen eine den Carbonsäureanhydriden vergleichbare Härtungscharakteristik.

Die Reaktivität der phsophormodifizierter Gießharzsysteme kann ebenso wie bei bekannten phosphorfreien Reaktionsharzsystemen durch die Zugabe von Beschleunigern gezielt eingestellt.

Die niedrig einstellbare Viskosität des erfindungsgemäßen Gießharzsystems macht einen hohen Füllstoffanteil möglich, der für eine Gießharzanwendung bis zu 70 Gewichtsprozent erreichen kann.

In einer Ausführungsform der Erfindung wird Alkanphosphonsäureanhydrid in einem Carbonsäureanhydrid, beispielsweise dem Anhydrid einer Di- oder Tetracarbonsäure gelöst und ergibt mit diesen eine lagerstabile Härterkomponente, die unter Feuchtigkeitsausschluß ohne wesentliche Veränderungen ihrer Eigenschaften mindestens ein Jahr lang gelagert werden kann.

Besonders geeignete Carbonsäureanhydride sind die Anhydride von aromatischen oder cycloaliphatischen Di-, Tetra- oder Polycarbönsäuren. Bevorzugt sind Carbonsäureanhydride, die bei Raumtemperatur flüssig sind. Doch auch feste Carbonsäureanhydride sind geeignet.

Doch nicht nur der Phosphorgehalt ist für die flammwidrigen Eigenschaften des erfindungsgemäßen Gießharzsystems bzw. des daraus hergestellten Formstoffes von Bedeutung, sondern auch das Carbonsäure-Anhydrid. Weitere Verbesserungen im Flammschutz werden erzielt, wenn das Anhydrid von einer aromatischen Di- oder Tetracarbonsäure abgeleitet ist. Das aromatische Gerüst der Carbonsäure kann dabei ein ein- oder mehrkerniger Aromat sein. Die einfachste Spezies dieser Gruppe von Verbindungen stellt Phthalsäureanhydrid dar.

Weitere Beispiele von geeigneten aromatischen Anhydriden sind Benzol-1,2,4,5-tetracarbonsäuredianhydrid, Benzophenontetracarbonsäuredianhydrid oder Perylen-3,4,9,10-tetracarbonsäure-3,4,9,10-dianhydrid, Naphthalin-1,8-dicarbonsäureanhydrid, Benzosäureanhydrid oder Biphenyltetracarbonsäuredianhydrid.

Neben den aromatischen Anhydriden werden auch cycloaliphatische, aliphatische und olefinische Anhydride eingesetzt, wie zum Beispiel Hexahydrophthalsäureanhydrid, Methylhexahydrophthalsäureanhydrid, Bernsteinsäureanhydrid, Valeriansäureanhydrid, Isovaleriansäureanhydrid, Hexansäureanhydrid, Pivalinsäureanhydrid, 5-Norbornen-2,3-dicarbonsäureanhydrid, Maleinsäureanhydrid, 2-Dodecenl-yl-bernsteinsäureanhydrid und Methyltetrahydrophthalsäureanhydrid.

Als Epoxidkomponenten (Komponente A) kann ein handelsübliches Epoxidharz oder ein Gemisch aus handelsüblichen Epoxidharzen ausgewählt werden. Besonders vorteilhaft haben sich dabei die Polyglycidylether auf Basis von Bisphenol-A und Bisphenol-F bewährt. Neben den besonders geeigneten aromatischen Polyglycidylethern sind auch solche von aliphatischen Alkoholen geeignet. Als Beispiele derartiger mehrwertiger Alkohole seien 1,4-Butandiol, 1,6 Hexandiol, Polyalkylenglykole, Glycerin, Trimethylolpropan, Bis-(4-hydroxycyclohexyl)-2,2-propan und Pentaerythrit genannt.

Auch Polyglycidylester sind geeignet, die man durch Umsetzung von beispielsweise Epichlorhydrin oder ähnlichen Epoxyverbindungen mit aliphatischen, cycloaliphatischen oder aromatischen Polycarbonsäuren erhält. Weiterhin sind für die Epoxidkomponente solche Polyepoxide geeignet, die durch Epoxidierung von Polyalkenen erhalten werden.

Da die Erfindung die Modifizierung eines herkömmlichen Epoxid/Anhydridreaktionsharzsystems betrifft, können im erfindungsgemäßen Gießharzsystem weitere Inhaltsstoffe (Komponenten D) enthalten sein. Dies sind an sich für Epoxidharze bekannte Zusätze, die die Verarbeitbarkeit, die Farbe oder die Eigenschaften des gehärteten Formstoffes beeinflussen, und die in Abhängigkeit von der gewünschten Anwendung ausgewählt sein können. Solche Zusätze können sein: Reaktivverdünner, Verlaufshilfsmittel, Entschäumer, Haftvermittler, Thixotropierungsmittel, Farbstoffe, Pigmente und insbesondere Füllstoffe. Neben einer Verbesserung der thermisch mechanischen Eigenschaften kann durch Füllstoffe die Flammwidrigkeit zusätzlich erhöht werden. Obwohl dies bereits mit einem hohen Füllstoffgehalt und damit einer Verringerung des Anteils der organischen Harzmatrix erreicht wird, kann auch durch die Auswahl des Füllstoffs die Flammfestigkeit verbessert werden. Ein mit dem erfindungsgemäßen Gießharzsystem gut kompatibler Füllstoff mit Flammschutzwirkung ist beispielsweise Aluminiumhydroxid.

Dabei bewirken bereits geringe Mengen Aluminiumhydroxid eine erhebliche Steigerung der Flammfestigkeit. Die niedrig einstellbare Viskosität der organischen Bestandteile des Gießharzsystems ermöglicht Füligrade bis zu 70 Gewichtsprozent mit den bekannten Füllstoffen, wie zum Beispiel Quarzmehl, Kreide und Aluminiumoxid.

Im erfindungsgemäßen Gießharzsystem verhalten sich die phosphorhaitigen Anhydride B2 und B3 wie die in der Epoxidharzchemie gebräuchlichen Carbonsäureanhydrid-Härter.

Ein Gießharzsystem mit exakt stöchiometrischem Verhältnis der Komponenten enthält daher so viel Epoxidequivalente, wie es der Summe der Equivalente an Carbonsäureanhydrid und phosphorhaltigem Anhydrid entspricht.

Mögliche Gießharzanwendungen sind zum Beispiel die Herstellung massiver Formkörper durch Verguß und Härtung des Gießharzsystems in einer Gießform, die Umhüllung aktiver und passiver elektrischer und elektronischer Bauelemente, beispielsweise ebenfalls durch Verguß in einer Gießform. Weitere Gießharzanwendungen sind Beschichtungen und Abdeckungen, die durch oberflächliche Applikation des erfindungsgemäßen Gießharzsystems erzeugt werden können.

Die Verarbeitung bzw. der Verguß des erfindungsgemäßen Gießharzsystems kann bei den in der Gießtechnologie üblichen Temperaturen erfolgen. Vorzugsweise werden jedoch Verarbeitungstemperaturen < 130°C gewählt, um eine vorzeitige Aushärtung des Gießharzsystems in der Applikationsvorrichtung zu unterdrücken. Während eine höhere Verarbeitungstemperatur zur Herabsetzung der Viskosität des Gießharzsystems dient, kann für reaktivere bzw. schneller härtende Gießharzsysteme eine niedrigere Verarbeitungstemperatur vorteilhaft sein.

Die Reaktivität des Gießharzsystems und damit die zur Verarbeitung erlaubten bzw. zur Härtung erforderlichen Bedingungen können durch geeignete Auswahl der Gießharzkomponenten eingestellt werden. Mit Hilfe der Reaktionsbeschleuniger, beispielsweise den bei Epoxidharzen gebräuchlichen Imidazolen wird die Härtung beschleunigt bzw. bei niedrigeren Temperaturen ermöglicht. Auch hier bestätigt sich die Beobachtung, daß durch den Zusatz des Alkanphosphonsäureanhydrids das Verhalten und übrigen Eigenschaften des Reaktionsharzsystems praktisch nicht beeinflußt werden.

Die durch Härtung des RGießharzsystems erhaltenen Formstoffe erfüllen die Flammschutznorm UL 94 V0 der Underwriters Laboratorien bis zu einer Probendicke von 0,8 mm in einem Ausführungsbeispiel mit 3 Prozent Phosphorgehalt (bezogen auf die organische Matrix) und 20 Prozent Füllstoff (Aluminiumhydroxid).

Ein weiteres Ausführungsbeispiel zeigt bereits bei einem Phosphorgehalt von 1 Prozent und 20 Prozent Aluminiumhydroxid und 40 Prozent Quarzmehl eine UL 94 VO-Einstufung bei 3,2 mm Probendicke.

Die aus den erfindungsgemäßen Gießharzsystemen hergestellten Formstoffe zeigen darüber hinaus selbst bei einem Phosphorgehalt von zum Beispiel 3 Prozent mit phosporfreien Epoxid-Anhydrid-Formstoffen vergleichbare mechanische, thermische, elektrische und chemische Eigenschaftswerte.

Sehr vorteilhaft wird das erfindungsgemäße Gießharzsystemangewendet für den Verguß von Hochspannungsbauteilen, insbesondere von Stützisolatoren in der Hochspannungsübertragung. Es handelt sich dabei um hochspannungsfeste Isolierbauteile, die stromführende Anlagenkomponenten gegenüber Erdpotential elektrisch isoliert mechanisch fixieren. Die dafür erforderlichen Gießharzmengen variieren je nach Bauelementgröße zwischen einigen 100 g und mehreren kg. Dabei wird das Gießharz getrennt als Harz- oder Härterkomponente, die den Reaktionsbeschleuniger mitumfaßt, aufbereitet. Anschließend werden die beiden Komponenten vereinigt und im Vakuum bei mäßiger Temperatur (90 - 100°C) homogenisiert. Der Verguß der Stützisolatoren wird dann bei angepaßter Form- und Massetemperatur nach der Vakuumgießtechnik bzw. für hochwertige Bauelemente nach dem Druckgelierverfahren durchgeführt. Üblicherweise werden die Stützer nach einer Anhärtephase heiß entformt und anschließend bei Temperaturen von ca. 140°C über mehrere Stunden ausgehärtet.

Ein mit dem erfindungsgemäßen Gießharzsystem hergestellter Stützertyp mit den Abmessungen - Höhe ca. 30 cm und Durchmesser ca. 10 cm - besitzt Umbruchfestigkeitswerte zwischen 8,6 und 8,9 kN und übersteht ein 10-minütiges Beflammen ohne Beanstandung. Er erfüllt damit den geforderten Qualitätsstandard.

Im folgenden wird die Erfindung anhand von Ausführungsbeispielen näher erläutert.

### 1. Beispiel

Zur Herstellung eines P-haltigen formulierten Carbonsäureanhydrids, bestehend aus Propanphosphonsäureanhydrid (PPA) und Hexahydrophthalsäureanhydrid (HHPSA) werden 104,0 Masseteile einer 50 prozentigen PPA-Lösung (entspricht im Beispiel 0,49 mol PPA) unter Feuchteausschluß in ein Gefäß eingewogen. Nach dem quantitativen Entfernen des Lösungsmittels Ethylacetat im Vakuum bei 60 - 80°C werden 52,0 Masseteile (im Beispiel 0,34 mol) auf ca. 60°C vorgewärmtes Hexahydrophthalsäureanhydrid zugemischt.

Dieses Phosphor-haltige Anhydridgemisch läßt sich durch die geringe Viskosität sehr gut verarbeiten.

Es weist eine Viskosität bei 80°C von nur 120 mPas und einen Phosphor-Gehalt von 14,5 % auf.

Unter Feuchteausschluß ist eine Lagerstabilität bei Raumtemperatur von mindestens einem Jahr gegeben.

### 2. Beispiel

100,0 Masseteile Epoxyphenolnovolak (DEN 438), 36,0 Masseteile des in Beispiel 1 hergestellten P-haltigen Anhydridgemischs, 39,3 Masseteile Hexahydrophthalsäureanhydrid, 1,0 Masseteile Beschleuniger 1-Cyanoethyl-2-phenylimidazol (2 PZ-CN) werden mit 42,8 Masseteilen Füllstoff Aluminiumhydroxid (Apyral 4) bei 60°C gemischt, entgast und 4 Stunden bei 130°C gehärtet.

Entsprechend hergestellte Normstäbe, die einen P-Gehalt von 3 % und einen Füllstoff-Gehalt von 20 % aufweisen, erfüllen die Flammschutznorm UL 94 V0 der Underwriters Laboratories bis zu einer Probendicke von 0,8 mm.

### 3. Beispiel

23,9 Masseteile eines Bisphenol-A-diglycidylethers (MY 740) werden mit 1,4 Masseteilen lösungsmittelfreiem Propanphosphonsäureanhydrid, 14,4 Masseteilen Phthalsäureanhydrid, 20,0 Masseteilen Aluminiumhydroxid (Apyral 4) und 40,0 Masseteilen Quarzmehl (Silbond FW EST 61) bei 130°C aufbereitet. Nach dem Aufschmelzen und Mischen werden 0,24 Masseteile Beschleuniger Dimethylbenzylamin zugegeben.

Das mit 60 Gewichtsprozent hochgefüllte Gießharz weist einen P-Gehalt von nur 1 % auf und ergibt nach Herstellung entsprechender Normstäbe bei einer Härtung von 3 Stunden bei 150°C hohe mechanische Formstoffeigenschaften. Es erfüllt die Flammschutzspezifikation nach UL 94 V0 bis zu einer Probendicke von 3,2 mm.

### 4. Beispiel

100,00 Masseteile Bisphenol-A-Diglycidylether (MY740) wurden mit 29,0 Masseteilen Ethylmethylphosphinsäureanhydrid (entspricht 0,15 mol), 49,6 Masseteilen Hexahydrophthalsäureanhydrid und 0,5 Masseteilen 1-Cyanoethyl-2-phenylimidazol bei 60°C gemischt.

Die niederviskose Epoxidgießharzmasse wird vor dem Einfüllen in eine entsprechende Gießform entgast und anschließend 1 Stunde bei 100°C und 2 h bei 150°C gehärtet.

Die hergestellten Normstäbe, die einen P-Gehalt von 5 Prozent aufweisen, ergeben eine Flammschutzspezifikation nach UL 94 VO bis zu einer Probendicke von 3,2 mm.

### 5. Beispiel

Für den Verguß von Stützisolatoren mit dem erfindungsgemäßen Reaktionsharzsystem wird das Gießharz zunächst als Harz- und Härterkomponente aufbereitet.

Zur Herstellung der Harzkomponente werden in einem geheizten Kessel (ca. 90°C) 813,0 Masseteile eines niedermolekularen Bisphenol-A-diglycidylethers (Araldit F), 207,0 Masseteile eines höhermolekularen Bisphenol-A-diglycidylethers (Araldit B 44), 1971,0 Masseteile Füllstoff, bestehend aus 1371,0 Masseteilen Quarzmehl 2500) und 600,0 Masseteilen Aluminiumhydroxid (Apyral 2), und 9,0 Masseteilen Farbstoff (Eisenoxid) gemischt.

Die B-Komponente wird ebenfalls in einem geheizten Kessel (Temperatur ca. 90°C) aufbereitet, bestehend aus 573,0 Masseteilen Hexahydrophthalsäureanhydrid (HAT 907), 6,0 Masseteilen Beschleuniger Dimethylbenzylamin (Desmorapid DB), 843,0 Masseteilen Quarzmehl (Christ-Quarzmehl 2500), 369,0 Masseteilen Aluminiumhydroxid (Apyral (2) und 57,0 Masseteilen lösungsmittelfreiem Propanphosphonsäureanhydrid.

Nach dem Vereinigen der Harz- und Härter-Komponenten wird das Gießharz, das 0,34 Gewichtsprozent Phosor, 20 Gewichtsprozent Aluminiumhydroxid und 45,6 Gewichtsprozent Quarzmehl enthält und das bei 90°C eine Viskosität von etwa 4000 mPas aufweist, in eine vorbereitete Gießform gefüllt, 3 Stunden bei 120°C vorgehärtet und anschließend heiß entformt. Der vergossene, ca. 3,5 kg schwere Stützisolator wird 6 Stunden bei 140°C nachgehärtet.

Ein mit dem phosphormodifizierten Gießharzformstoff ausgerüsteter Stützisolator ist für den Einsatz in Hochspannungsübertragungsanlagen qualifiziert . Er erfüllt insbesondere die Anforderungen hinsichtlich halogenfreier Flammwidrigkeit, Kriechstromfestigkeit und Umbruchfestigkeit.

## Patentansprüche

1. Gießharzsystem mit
A einer Epoxidkomponente
B einer Härterkomponente, bestehend aus
B1 und B2
oder
B1 und B3,
wobei
B1 ein Anhydrid einer Carbonsäure,
B2 ein Phosphonsäureanhydrid der allgemeinen Strukturformel 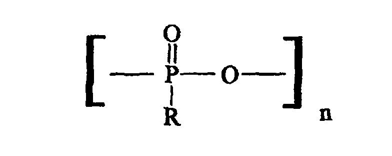
B3 ein Phosphinsäureanhydrid der allgemeinen Strukturformel 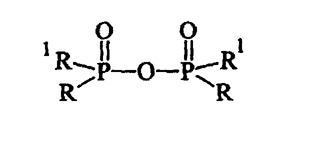 umfaßt, bei dem R und R¹ unabhängig voneinander ein Alkyl- oder Alkenylrest mit 1 bis 40 C-Atomen oder ein cycloaliphatischer oder ein Arylrest und n eine ganze Zahl ist, und mit
C einem Reaktionsbeschleuniger.

2. Gießharzsystem nach Anspruch 1,
bei dem die Härterkomponente B eine Lösung des Phosphonsäureanhydrids oder des Phosphinsäureanhydrids in einem Di- oder Tetracarbonsäureanhydrid ist, die zumindest bei der Verarbeitungstemperatur des Gießharzsystems flüssig ist.

3. Gießharzsystem nach Anspruch 2,
bei dem die Härterkomponente B1 ein Anhydrid einer aromatischen oder cycloaliphatischen Di- oder Tetracarbonsäure umfaßt.

4. Gießharzsystem nach einem der Ansprüche 1 bis 3,
welches weitere für Epoxidharze übliche Zusätze enthält, die ausgewählt sind aus
D Reaktivverdünner, Füllstoff, Verlaufshilfsmittel, Haftvermittler, Thixotropierungsmittel, Farbstoff und Pigmente.

5. Verfahren zur Herstellung eines flammwidrigen Gießharzformstoffes durch
miteinander Vermischen der Komponenten A, B1, B2 und C)oder A, B1, B3 und C, wobei
A eine Epoxidkomponente,
B1 ein Anhydrid einer Carbonsäure,
B2 ein Phosphonsäureanhydrid der allgemeinen Strukturformel 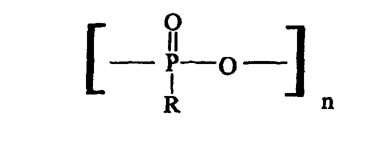
und B3 ein Phosphinsäureanhydrid der allgemeinen Strukturformel 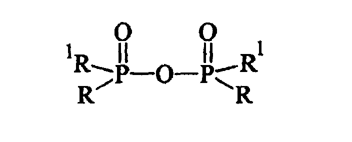 umfaßt, in der R und R¹ unabhängig voneinander ein Alkyl- oder Alkenylrest mit 1 bis 40 C-Atomen oder ein cycloaliphatischer oder ein Arylrest und n eine ganze Zahl ist,
C ein Reaktionsbeschleuniger
und
Aushärten bei erhöhter Temperatur.

6. Verfahren nach Anspruch 5,
bei dem vor dem Aushärten noch eine weitere Komponente D zugemischt wird, welche ausgewählt ist aus
D Reaktivverdünner, Füllstoff, Verlaufshilfsmittel, Haftvermittler, Thixotropierungsmittel, Farbstoff und Pigment.

7. Verfahren nach Anspruch 5 oder 6,
- bei dem eine Härterkomponente B durch Lösen des Phosphonsäureanhydrids B2 oder des Phosphinsäureanhydrids B3 in dem Anhydrid B1 der Carbonsäure hergestellt wird
- der Härterkomponente B ein Reaktionsbeschleuniger C zugesetzt wird
- bei dem die Härterkomponente B mit dem Reaktionsbeschleuniger C und einer Polyepoxidverbindung A, die zumindest zwei Epoxidgruppen pro Molekül aufweist, und gegebenenfalls weiteren für Epoxidharze üblichen Zusätzen oder Füllstoffen D zu einer Gießharzmischung vermischt wird,
- bei dem der Anteil des Phosphonsäureanhydrids B2 oder des Phosphinsäureanhydrids B3 so bemessen wird, daß der Phosphorgehalt der organischen Bestandteile zwischen 1 und 5 Gewichtsprozent liegt
- bei dem die Gießharzmischung bei erhöhter Temperatur gehärtet wird.

8. Verwendung des Gießharzsystems nach einem der Ansprüche 1 bis 4 zur Herstellung flammwidriger Gießharzformkörper, Gießharzabdeckung oder Gießharzumhüllung für insbesondere elektrische und elektronische Bauelemente.

9. Verwendung des Gießharzsystems nach einem der Ansprüche 1 bis 4 zur Herstellung flammwidriger Gießharzumhüllungen für Stützisolatoren in Hochspannungsübertragungsanlagen.

## Claims

1. Casting resin system with
A an epoxide component
B a hardener component consisting of
B1 and B2
or
B1 and B3,
where
B1 is an anhydride of a carboxylic acid,
B2 is a phosphonic anhydride of the general structural formula 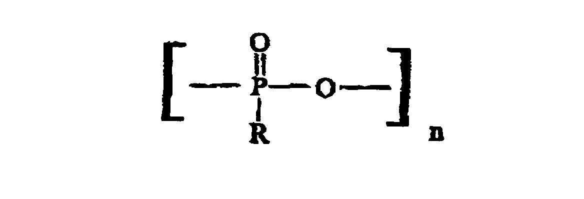
B3 is a phosphinic anhydride of the general structural formula 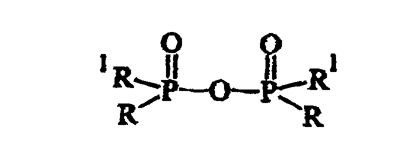 where R and R¹ are independently an alkyl or alkenyl radical having 1 to 40 carbon atoms, a cycloaliphatic radical or an aryl radical, and n is a whole number, and with
C a reaction accelerant.

2. Casting resin system according to Claim 1, wherein the hardener component B is a solution of the phosphonic anhydride or of the phosphinic anhydride in a di- or tetracarboxylic anhydride that is liquid at least at the processing temperature of the casting resin system.

3. Casting resin system according to Claim 2, wherein the hardener component B1 comprises an anhydride of an aromatic or cycloaliphatic di- or tetracarboxylic acid.

4. Casting resin system according to any of Claims 1 to 3, further containing customary epoxy resin additives selected from
D reactive diluent, filler, flow assistant, adhesion promoter, thixotroping agent, dye and pigments.

5. Process for preparing a flame-retardant cast resin material by
mixing together the components A, B1, B2 and C or A, B1, B3 and C, where
A is an epoxide component,
B1 is an anhydride of a carboxylic acid,
B2 is a phosphonic anhydride of the general structural formula 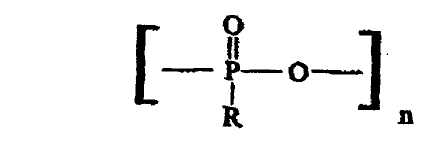
and
B3 is a phosphinic anhydride of the general structural formula 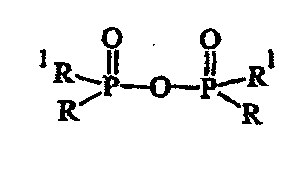 where R and R¹ are independently an alkyl or alkenyl radical having 1 to 40 carbon atoms, a cycloaliphatic radical or an aryl radical, and n is a whole number, and with
C a reaction accelerant, and
curing at elevated temperature.

6. Process according to Claim 5, wherein the curing is preceded by admixing a further component D selected from
D reactive diluent, filler, flow assistant, adhesion promoter, thixotroping agent, dye and pigment.

7. Process according to Claim 5 or 6,
- wherein a hardener component B is prepared by dissolving the phosphonic anhydride B2 or the phosphinic anhydride B3 in the anhydride B1 of the carboxylic acid
- the hardener component B has a reaction accelerant C added to it
- wherein the hardener component B is mixed with the reaction accelerant C and a polyepoxide compound A, which has at least two epoxide groups per molecule, and optionally further customary epoxy resin additives or fillers D to form a casting resin mixture,
- wherein the fraction of the phosphonic anhydride B2 or of the phosphinic anhydride B3 is determined so that the phosphorus content of the organic constituents is between 1 and 5 per cent by weight
- wherein the casting resin mixture is cured at elevated temperature.

8. Use of the casting resin system according to any of Claims 1 to 4 for producing flame-retardant cast resin articles, cast resin covering or cast resin encapsulation for electrical and electronic components in particular.

9. Use of the casting resin system according to any of Claims 1 to 4 for producing flame-retardant cast resin encapsulations for support insulators in in high-voltage transmission systems.

## Revendications

1. Système de résine de coulée avec
A un composant époxyde
B un composant durcisseur, constitué de
B1 et de B2
ou
B1 et B3,
dans lequel
B1 comprend un anhydride d'un acide carboxylique,
B2 comprend un anhydride d'acide phosphonique de formule développée générale 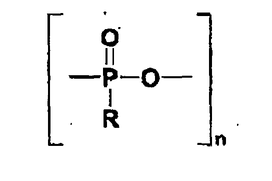
B3 comprend un anhydride d'acide phosphinique de formule développée générale 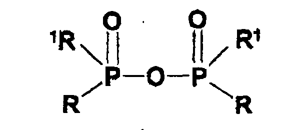 dans lequel R et R¹ représentent indépendamment l'un de l'autre un résidu alkyle ou alcényle ayant 1 à 40 atomes de C ou un résidu cycloaliphatique ou un résidu aryle et n est un nombre entier, et avec
C un accélérateur de réaction.

2. Système de résine de coulée selon la revendication 1, dans lequel le composant durcisseur B est une solution de l'anhydride phosphonique ou de l'anhydride phosphinique dans un anhydride di- ou tétra-carboxylique, qui est au moins liquide à la température de traitement du système de résine de coulée.

3. Système de résine de coulée selon la revendication 2, dans lequel le composant durcisseur B1 comprend un anhydride d'un acide di- ou tétracarboxylique, aromatique ou cycloaliphatique.

4. Système de résine de coulée selon l'une quelconque des revendications 1 à 3,
lequel contient des additifs supplémentaires habituels pour les résines époxydes, qui sont choisies parmi
D un diluant de réactif, une charge, un agent rhéologique, un agent adhésif, un agent thixotrope, un colorant et des pigments.

5. Procédé de préparation d'une matière à mouler, à base de résine de coulée ignifuge, par mélange mutuel des composants A, B1, B2 et C, ou A, B1, B3 et C,
A comprenant un composant époxyde,
B1 comprenant un anhydride d'un acide carboxylique
B2 comprenant un anhydride phosphonique de formule développée générale 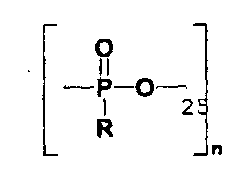
et B3 comprenant un anhydride phosphinique de formule développée générale 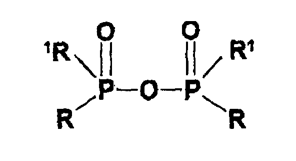 dans laquelle R et R¹ représentent indépendamment l'un de l'autre, un résidu alkyle ou alcényle ayant 1 à 40 atomes de C ou un résidu cycloaliphatique ou aryle et n est un nombre entier,
C est un accélérateur de réaction
et
par durcissement à une température élevée.

6. Procédé selon la revendication 5,
dans lequel avant le durcissement on ajoute en mélangeant encore un autre composant D qui est choisi parmi
D un diluant de réactif, une charge, un agent rhéologique, un agent adhésif, un agent thixotrope, un colorant et un pigment

7. Procédé selon la revendication 5 ou 6,
- dans lequel un composant durcisseur B est préparé en dissolvant l'anhydride phosphonique B2 ou l'anhydride phosphinique B3 dans l'anhydride carboxylique B1.
- un accélérateur de réaction C est ajouté au composant durcisseur B
- dans lequel le composant durcisseur B est mélangé avec l'accélérateur de réaction C et un composé polyépoxyde A qui présente au moins deux groupes époxyde par molécule, et éventuellement d'autres additifs ou charges D usuelles pour les résines époxydes pour obtenir un mélange de résine de coulée,
- dans lequel la proportion de l'anhydride phosphonique B2 ou de l'anhydride phosphinique B3 est dimensionnée de telle sorte que la teneur en phosphore des composants organiques est comprise entre 1 et 5% en poids,
- dans lequel le mélange de résine de coulée est durci à une température élevée.

8. Utilisation du système de résine de coulée selon l'une quelconque des revendications 1 à 4, pour préparer un corps moulé en résine de coulée ignifuge, une couverture en résine de coulée ou une enveloppe en résine de coulée en particulier pour des composants électriques et électroniques.

9. Utilisation du système de résine de coulée selon l'une quelconque des revendications 1 à 4, pour préparer des enveloppes en résine de coulée ignifuges pour des isolateurs supports dans des installations de transmission de haute tension.
